# EUROPÄISCHE PATENTSCHRIFT

(11) **EP 0 786 866 B1**
(45) Veröffentlichungstag und Bekanntmachung des Hinweises auf die Patenterteilung: **10.11.2004**
(21) Anmeldenummer: 96119674.8
(22) Anmeldetag: 09.12.1996
(51) Int. Cl.: H03K 4/62

(54) **Steuerschaltung für einen periodisch betätigten Schalttransistor**
Driving circuit for a periodically operated switch transistor
Circuit de commande pour un transistor de commutation déclenché périodiquement

(30) Priorität: 25.01.1996 DE 19602556
(43) Veröffentlichungstag der Anmeldung: 30.07.1997
(73) Patentinhaber: DEUTSCHE THOMSON-BRANDT GMBH, 78048 Villingen-Schwenningen (DE)
(72) Erfinder: Francois, Yves, 78050 Villingen-Schwenningen (DE); Rilly, Gerard, 78089 Unterkirnach (DE); Lopez, Daniel, 78052 Villingen-Schwenningen (DE)

(56) Entgegenhaltungen:
- EP-A- 0 403 972
- US-A- 4 612 451
- US-A- 4 864 247

## Beschreibung

Die Erfindung geht aus von einer Steuerschaltung für einen periodisch betätigten Schalttransistor gemäß dem Oberbegriff des Anspruchs 1. Ein derartiger Schalttransistor wird z.B. in der Zeilenendstufe für einen Fernsehempfänger oder in einem Schaltnetzteil benötigt.

Sowohl bei Zeilenablenkschaltungen als auch bei Schaltnetzteilen werden zunehmend höhere Arbeitsfrequenzen angewendet, bei der Zeilenablenkung für hochauflösende Systeme bei einer Zeilenfrequenz von 32 kHz und bei Schaltnetzteilen, um die Abmessungen des Trenntransformators weiter zu verringern. Mit der Erhöhung der Arbeitsfrequenz steigen proportional die Einschalt- und Ausschaltverluste an dem Schalttransistor an. Man ist daher bemüht, diese Ein- und Ausschaltverluste an dem Schalttransistor zu verringern, um den Gesamtwirkungsgrad der Schaltung zu verbessern.

Die US-A-4,612,451 offenbart eine Steuerschaltung für einen Schalttransistor, die einen Transformator mit zwei gegensinnig gewickelte Wicklungen enthält. Die mit dem Schalttransistor gekoppelte Wicklung weist hierbei einen Abgriff auf, der über eine Diode mit Masse verbunden ist. Hierdurch können die zum Sperren und zum Durchschalten des Schalttransistors benötigten Ströme in einem bestimmten Verhältnis zueinander eingestellt werden.

Aus der US-A-4,864,247 ist eine Steuerschaltung für einen Schalttransistor bekannt, die eine Spule mit zwei Abgriffen aufweist. Ein Abgriff ist hierbei über eine Diode mit einer negativen Spannung verbunden, und der zweite Abgriff ist mit der Basis des Schalttransistors verbunden. Die EP-A-0 403 972 offenbart eine Steuerschaltung für einen Schalttransistor, die einen Transformator mit zwei gegensinnig gewickelten Wicklungen aufweist.

Der Erfindung liegt die Aufgabe zugrunde, eine Steuerschaltung für einen derartigen Schalttransistor zu schaffen, mit der die Ein- und Ausschaltverluste an dem Schalttransistor verringert werden. Diese Aufgabe wird durch die im Anspruch 1 angegebene Erfindung gelöst. Vorteilhafte Weiterbildungen der Erfindung sind in den Unteransprüchen angegeben.

Die Erfindung besteht somit darin, daß eine Gleichspannungsquelle über ein periodisch betätigtes Schalterelement und eine Spule mit einem Kern und mit einem Abgriff an die Basis des Schalttransistors angeschlossen ist, daß die beiden Spulenteile gegensinnig gewickelt sind und daß der Abgriff über eine Diode mit Masse oder dem Emitter des Schalttransistors verbunden ist. Weiterhin ist ein Umladeweg vorgesehen, über den während der Entmagnetisierungsphase der Spule die in Form eines Stromes in der Spule gespeicherte Energie in Form einer negativen Spannung in einen Kondensator übertragen wird, wobei diese negative Spannung in der darauffolgenden Restzeit der Arbeitsperiode als Sperrspannung an die Basis des Schalttransistors angelegt ist.

Die erfindungsgemäße Steuerschaltung für den Schalttransistor hat gegenüber bekannten Schaltungen mehrere Vorteile. Die Schaltung ist besonders einfach, weil sie nur wenige passive preiswerte Bauteile benötigt. Es wird insbesondere ein sehr schnelles und verlustfreies Ausschalten des Schalttransistors erzielt. Die Schaltung wirkt dabei als Stromtransformator mit nur einer Induktivität, während ein echter Stromtransformator mit Primärwicklung und Sekundärwicklung nicht benötigt wird. Der Basisstrom während der leitenden Phase des Schalttransistors ist in erwünschter Weise proportional zum Kollektorstrom des Schalttransistors, d.h. steigt von null anfangend während der leitenden Phase des Schalttransistors sägezahnförmig an. Durch diese dynamische Anpassung des Basisstromes an den Kollektorstrom des Schalttransistors werden die Verluste an dem Schalttransistor während dieser Zeit verringert und ein besserer Wirkungsgrad erzielt. Die Schaltung ermöglicht insbesondere bei erhöhten Arbeitsfrequenzen eine beträchtliche Verringerung der am Schalttransistor auftretenden Verluste.

Vorzugsweise beträgt das Windungsverhältnis zwischen dem mit dem Schalter verbundenen Spulenteil und dem mit der Basis des Schalttransistors verbundenen Spulenteil etwa 3:1. Durch diese Bemessung wird eine optimale Amplitude des negativen Basisstromes des Schalttransistors während der Ausräumphase sichergestellt.

Bei einer Weiterbildung der Erfindung ist das mit dem Schalterelement verbundene Ende des ersten Spulenteils über die Reihenschaltung einer Diode und eines Kondensators mit Masse verbunden. Dabei ist der Kondensator über einen Widerstand mit der Basis des Schalttransistors verbunden. Bei dieser Schaltung dient der Kondensator nach der Ausräumphase zur Entladung der Spule. Dabei wird die in Form eines Stromes in der Spule gespeicherte Energie in Form einer Spannung in diesen Kondensator übertragen. Die am Kondensator auftretende Spannung dient dabei zur Sperrung des Schalttransistors. Der Kondensator erfüllt also in vorteilhafter Weise zwei Aufgaben, nämlich Übernahme der Energie in der Spule nach der Ausräumphase zwecks Entladung der Spule und Bereitstellung einer negativen Spannung an der Basis des Schalttransistors für diese Zeit.

Die Gleichspannungsquelle kann auch durch eine Gleichrichterschaltung gebildet sein, die von einer Wicklung eines von dem Schalttransistor gesteuerten Transformators gespeist ist. Dadurch kann die Gesamtschaltung vereinfacht werden. Gegebenenfalls ist dann eine Anlaufschaltung zum Starten der Schaltung erforderlich. Der Schalter kann durch einen Transistor oder einen MOS-FET gebildet sein.

Die Erfindung wird im folgenden anhand der Zeichnung erläutert.
Darin zeigen
- Fig. 1: ein Schaltungsbeispiel für die erfindungsgemäße Schaltung,
- Fig. 2: Kurven zur Erläuterung der Wirkungsweise der Schaltung nach Fig. 1,
- Fig. 3: den Aufbau der Spule mit dem Kern und
- Fig. 4: ein praktisch erprobtes Ausführungsbeispiel der Schaltung gemäß Fig. 1.

In der Beschreibung werden die folgende Symbole verwendet.
- ib: Basisstrom des Schalttransistors
- ic: Kollektorstrom des Schalttransistors

- i1: Maximalwert des positiven Basisstroms
- i2: Maximalwert des negativen Basisstroms
- i2': Basisstrom am Ende der Ausräumphase

- n1: Windungszahl des Spulenteils L1
- n2: Windungszahl des Spulenteils L2

- UD: Durchbruchspannung der Dioden
- Ube: Basis/Emitter-Flußspannung des Schalttransistors

- U2: erzeugte Betriebsspannung
- Us: Schaltspannung

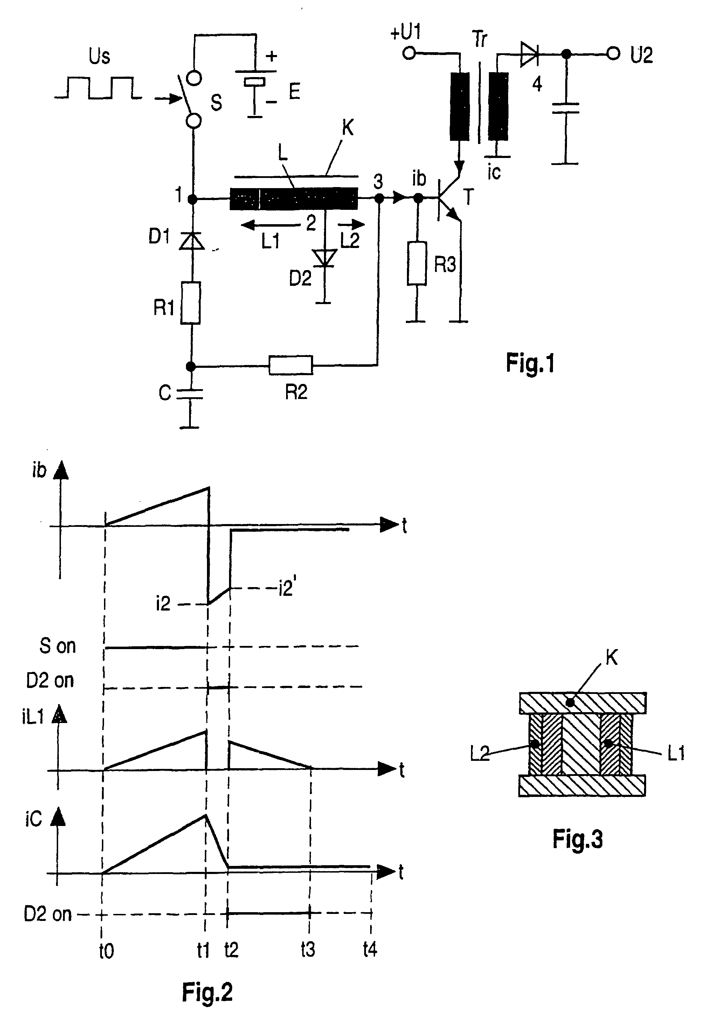

Fig. 1 zeigt ein Schaltnetzteil mit dem Schalttransistor T, dem Trenntransformator Tr und der Gleichrichterschaltung 4 zur Erzeugung einer Betriebsspannung U2. Vorzugsweise enthält der Trenntransformator Tr mehrere Sekundärwicklungen zur Erzeugung von Betriebsspannungen unterschiedlicher Amplitude und Polarität. Der Schalttransistor T wird von einer Steuer- oder Treiberschaltung periodisch geöffnet und gesperrt. Die Steuerschaltung enthält die Spannungsquelle E, den durch die Schaltspannung Us periodisch betätigten Schalter S, die Spule L mit dem Kern K und den beiden gegensinnig gewickelten Spulenteilen L1 und L2 und einem Abgriff 2, der über die Diode D2 geerdet ist. Der mit dem Schalter S verbundene Abgriff 1 der Spule L ist über die Reihenschaltung der Diode D1, des Widerstandes R1 und des Kondensators C mit Masse verbunden, wobei der Kondensator C über den Widerstand R2 mit der Basis des Schalttransistor T verbunden ist. Dessen Basis ist über den Widerstand R3 mit Masse verbunden.

Die Wirkungsweise der Steuerschaltung wird im folgenden nacheinander für die unterschiedlichen Vorgänge während einer Arbeitsperiode anhand der Fig. 2 beschrieben.

### Leitende Phase des Schalttransistor T von t0 - t1

Es sei angenommen, daß die Schaltung im Zeitpunkt t0 zu Beginn der Arbeitsperiode strom- und spannungslos ist. Bei t0 wird der Schalter S durch die Schaltspannung Us geschlossen, so daß am Abgriff 1 der Spule L die positive Spannung E anliegt. Dadurch beginnt über die Spule L ein Basisstrom ib in die Basis des Schalttransistors T zu fließen, der aufgrund der Induktivität der Spule L sägezahnförmig ansteigt und einen proportionalen Kollektorstrom ic durch den Schalttransistor T erzeugt. Am Abgriff 2 der Spule L steht durch gegenseitige Wicklung der beiden Spulenteile L1, L2 eine negative Spannung, so daß die Diode D2 während dieser Zeit gesperrt ist.

### Ausräumphase von t1- t2

Im Zeitpunkt t1 zu Beginn der Ausräumphase wird der Schalter S durch die Schaltspannung Us geöffnet. In den Abgriff 1 der Spule L kann dann kein Strom mehr fließen. Die Magnetisierung ist nun vollständig in der Spule konzentriert, wobei der Magnetisierungsstrom zunächst weiter fließen muß. Es fließt jetzt ein starker negativer Basisstrom ib von der Basis des Schalttransistors T über den Spulenteil L2 zwischen den Abgriffen 2 und 3 und die nunmehr leitende Diode D2 nach Masse. Dabei ändert sich die Magnetisierung relativ langsam von dem Wert i2 bis zum Wert i2'. Am Ende der Ausräumphase, also im Zeitpunkt t2, ist jedoch die Spule L noch nicht vollständig entladen.

### Entladung der Spule L oder Entmagnetisierungsphase

Die Basis des Schalttransistors T ist jetzt endgültig entladen, d.h. alle Ladungsträger sind ausgeräumt, und der Kollektorstrom ic ist auf null abgeklungen. Die Impedanz an der Basis steigt jetzt nennenswert an, so daß in die Basis kein nennenswerter Strom mehr fließen kann. Der in der Spule L noch fließende Strom muß daher einen anderen Weg finden. Dieser Strom fließt jetzt von dem Kondensator C über den Widerstand R1, die Diode D1, den Spulenteil L1 zwischen den Abgriffen 1 und 2 und die Diode D2. Im Zeitpunkt t3 ist die Spule L vollständig entladen, d.h. die in Form des Stromes in der Spule L gespeicherte Energie ist in Form einer negativen Spannung in den Kondensator C übertragen worden.

### Restzeit während der Arbeitsperiode

Während der Restzeit t3 - t4 der Arbeitsperiode t0 - t4, in der alle Ströme auf null abgeklungen sind, steht die am Kondensator C durch die Entmagnetisierung der Spule L entstandene negative Spannung an der Basis des Schalttransistor T und bewirkt dessen weitere Sperrung. Der für die Entladung der Spule L dienende Kondensator C stellt also gleichzeitig die durch seine Aufladung entstandene negative Spannung der Basis des Schalttransistors T als Sperrspannung zur Verfügung. Im Zeitpunkt t4, der dem Zeitpunkt t0 entspricht, ist somit die Schaltung zu Beginn der nächsten Arbeitsperiode durch Schließen des Schalters S vorbereitet.

Fig 3 zeigt den Kern K mit den beiden als Lagenwicklungen ausgebildeten Spulenteilen L1, L2. Der Kern K ist als sogenannter Rollen- oder Pilzkern ausgebildet.

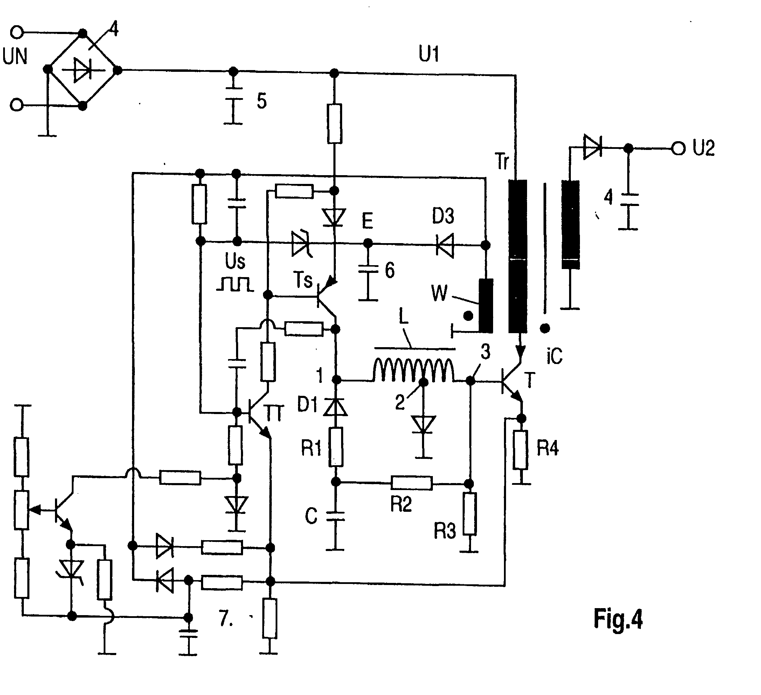

Fig. 4 zeigt wieder die Bauteile von Fig. 1. Die Betriebsspannung U1 für den Schalttransistor T wird aus der Netzspannung UN über den Netzgleichrichter 4 und den Ladekondensator 5 gewonnen. Die positive Spannung E wird durch Gleichrichtung der an der Wicklung W stehenden Impulsspannung mit der Diode D3 und den Kondensator 6 gewonnen. Der Strom-Meßwiderstand R4 im Emitterweg des Schalttransistor T liefert eine dem Kollektorstrom ic proportionale Spannung, die über die Schwellwertschaltung 7 eine Abschaltung des Schalttransistors T bei einem bestimmten Kollektorstrom ic bewirkt. Der Schalter S von Fig. 1 wird durch den Transistor Ts gebildet und die Schaltspannung Us für den Transistor Ts wird dadurch erzeugt, daß das dargestellte Schaltnetzteil durch die Wicklung W selbstschwingend ausgebildet ist. Der Transistor TT bildet eine Treiberschaltung für den Transistor Ts.

Bei einem praktisch erprobten Ausführungsbeispiel hatten die Bauteile folgende Werte:

| | |
|---|---|
| Kondensator C: | 10 nF |
| Widerstand R1: | 47 Ohm |
| Widerstand R2: | 470 Ohm |
| Widerstand R3 | 470 Ohm |
| Widerstand R4 | 0,2 Ohm |
| Transistor Ts: | Typ BC369 |
| n1: | 40 Windungen |
| n2: | 13 Windungen |
| K: | Rollen-oder Pilz-Kern |

## Patentansprüche

1. Steuerschaltung für einen periodisch betätigten Schalttransistor (T), der in Reihe mit der Primärwicklung eines Transformators (Tr) an einer Betriebsspannung (U1) liegt, und wobei eine Gleichspannungsquelle (E) über ein periodisch betätigtes Schalterelement (S) und eine Spule (L) mit einem Kern (K) und einem Abgriff (2) an die Basis des Schalttransistors (T) angeschlossen ist, die beiden Spulenteile (L1, L2) gegensinnig gewickelt sind und der Abgriff (2) über eine Diode (D2) mit Masse oder dem Emitter des Schalttransistors (T) verbunden ist, **dadurch gekennzeichnet, dass** ein Umladeweg (C, R1, D1, D2) vorgesehen ist, über den während der Entmagnetisierungsphase (t2 - t3) der Spule (L) die in Form eines Stromes in der Spule (L) gespeicherte Energie in Form einer negativen Spannung in einen Kondensator (C) übertragen wird, und dass diese negative Spannung in der darauffolgenden Restzeit (t3 - t4) der Arbeitsperiode (t0 - t4) als Sperrspannung an die Basis des Schalttransistors (T) angelegt ist.

2. Schaltung nach Anspruch 1, **dadurch gekennzeichnet, dass** das Windungsverhältnis (n1:n2) zwischen dem mit dem Schalter (S) verbundenen Spulenteil (L1) und dem mit der Basis des Schalttransistors (T) verbundenen Spulenteil (L2) etwa 3:1 beträgt.

3. Schaltung nach Anspruch 1, **dadurch gekennzeichnet, dass** das mit dem Schalterelement (S) verbundene Ende (1) des ersten Spulenteils (L1) über die Reihenschaltung einer Diode (D1) und eines Kondensators (C) mit Erde verbunden ist.

4. Schaltung nach Anspruch 3, **dadurch gekennzeichnet, dass** der Kondensator (C) über einen Widerstand (R2) mit der Basis des Schalttransistors (T) verbunden ist.

5. Schaltung nach Anspruch 4, **dadurch gekennzeichnet, dass** in Reihe mit der Diode (D1) ein Widerstand (R1) liegt.

6. Schaltung nach Anspruch 1, **dadurch gekennzeichnet, dass** die Gleichspannungsquelle (E) durch eine Gleichrichterschaltung gebildet ist, die von einer Wicklung (W) eines von dem Schalttransistor (T) gesteuerten Transformators (Tr) gespeist ist.

7. Schaltung nach Anspruch 1, **dadurch gekennzeichnet, dass** der Schalter (S) durch einen Transistor oder einen MOS-FET gebildet ist.

## Claims

1. Control circuit for a periodically actuated switching transistor (T), which is connected in series with the primary winding of a transformer (Tr) to an operating voltage (U1) and wherein a DC voltage source (E) is connected to the base of the switching transistor (T) via a periodically actuated switch element (S) and a coil (L) having a core (K) and a tap (2), the two coil parts (L1, L2) are wound in opposite senses, and the tap (2) is connected via a diode (D2) to earth or to the emitter of the switching transistor (T),
**characterized in that** a charge-reversal path (C, R1, D1, D2) is provided via which, during the demagnetization phase (t2-t3) of the coil (L), the energy stored in the form of a current in the coil (L) is transferred to a capacitor (C) in the form of a negative voltage, and **in that** this negative voltage is applied during the succeeding residual time (t3 - t4) of the operating period (t0 - t4) as a reverse voltage to the base of the switching transistor (T).

2. Circuit according to claim 1, **characterized in that** the turns ratio (n1 : n2) between the coil part (L1) connected to the switch (S) and the coil part (L2) connected to the base of the switching transistor (T) is about 3:1.

3. Circuit according to claim 1, **characterized in that** that end (1) of the first coil part (L1) which is connected to the switch element (S) is connected to earth via the series circuit formed by a diode (D1) and a capacitor (C).

4. Circuit according to claim 3, **characterized in that** the capacitor (C) is connected via a resistor (R2) to the base of the switching transistor (T).

5. Circuit according to claim 4, **characterized in that** a resistor (R1) is connected in series with the diode (D1).

6. Circuit according to claim 1, **characterized in that** the DC voltage source (E) is formed by a rectifier circuit which is fed by a winding (W) of a transformer (Tr) which is controlled by the switching transistor (T).

7. Circuit according to claim 1, **characterized in that** the switch (S) is formed by a transistor or a MOSFET.

## Revendications

1. Circuit de commande pour un transistor de commutation (T) déclenché périodiquement, raccordé en série avec l'enroulement du circuit primaire d'un transformateur (Tr) et alimenté par une tension de fonctionnement (U1), et où une source de tension continue (E) est raccordée à la base du transistor de commutation (T) via un commutateur déclenché périodiquement (S) et une bobine (L) avec un noyau (K) et une prise (2), où les deux bobines (L1, L2) sont enroulées dans le sens opposé et où la prise (2) est reliée à la masse ou à l'émetteur du transistor de commutation (T) via une diode (D2), **caractérisé en ce qu'un** chemin alternatif (C, R1, D1, D2) est prévu, via lequel l'énergie stockée sous la forme d'un courant dans la bobine (L) pendant la phase de démagnétisation (t2 -t3) de la bobine (L) est transmise dans un condensateur (C) sous la forme d'une tension négative, et
**caractérisé en ce que** cette tension négative est appliquée comme tension de blocage à la base du transistor de commutation (T) au cours du temps résiduel (t3-t4) de la phase de travail (t0-t4)

2. Circuit selon la revendication 1, **caractérisé en ce que** le rapport de spires (n1;n2) entre la bobine (L1) reliée au commutateur (S) et la bobine (L2) reliée à la base du transistor de commutation (T) est d'environ 3:1.

3. Circuit selon la revendication 1, **caractérisé en ce que** l'extrémité (1) de la première bobine (L1) reliée au commutateur (S) est reliée à la terre via le montage en série d'une diode (D1) et d'un condensateur (C).

4. Circuit selon la revendication 3, **caractérisé en ce que** le condensateur (C) est relié à la base du transistor de commutation (T) via une résistance (R2).

5. Circuit selon la revendication 4, **caractérisé en ce qu'une** résistance (R1) est alignée avec une diode (D1).

6. Circuit selon la revendication 1, **caractérisé en ce que** la source de courant continue (E) est formée par un circuit redresseur alimenté par une spire (W) d'un transformateur (Tr) commandé par le transistor de commutation (T).

7. Circuit selon la revendication 1, **caractérisé en ce que** le commutateur (S) est formé par un transistor ou un MOS-FET.
